# EUROPEAN PATENT APPLICATION

(11) **EP 0 626 722 A1**
(43) Date of publication of application: **30.11.1994**
(21) Application number: 93903332.0
(22) Date of filing: 09.02.1993
(51) Int. Cl.: H01L 21/3205, H01L 23/532

(54) **SEMICONDUCTOR DEVICE AND ITS MANUFACTURE**

(30) Priority: 10.02.1992 JP 57354/92
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9300165
(87) International publication number: WO9316487

(57) **Abstract**

A semiconductor device having an excellent migration resistance, a long life, and a shorter delay in its inner wiring, and a method for manufacturing such a device. Copper wire the width of which is smaller than 1 µm and the grain size of which is more than ten times the wiring width is partly used.

## Description

### Technical Field

The present invention relates to a semiconductor device and a manufacturing method therefor, and in particular, relates to a semiconductor device which is applicable to ultra-LSI processes, as well as to a manufacturing method therefor.

### Background Art

Conventionally, aluminum or aluminum alloys were used as the wiring material for semiconductor elements. In manufacturing processes for aluminum wiring, a vacuum evaporation method was employed in which, in the presence of a strong vacuum, aluminum was vaporized by heating and caused to be deposited on a wafer. Aluminum is low in cost and has a low melting point, so that it is easily handled and finds many applications as a wiring material.

Furthermore, techniques were known in which aluminum alloys were used as wiring material. Examples of such aluminum alloys are aluminum-silicon, aluminum-silicon-copper, and the like, and in the manufacturing process therefor, a sputtering method was employed in which atoms which were abraded from a target by means of high-speed particles in a plasma were deposited on a wafer. In comparison with aluminum, the service life of aluminum alloy wiring is somewhat longer, and such wiring is stable with respect to heat processing, so that such aluminum alloys have come to be used in concert with aluminum as wiring materials.

Next, the difficulties encountered when employing aluminum or aluminum alloys as wiring in the conventional manner will be explained.

With respect to the service life of the wiring, disconnection resulting from electromigration presented a large problem. This is a phenomenon in which momentum transfer occurs between electrons and atoms when electricity is caused to flow through wiring, and atoms migrate in the direction of electron flow. When the electron density in the wiring increases, localized voids appear in which atoms are exhausted and disconnections occur, or localized hillocks are formed at points at which atoms are concentrated.

When the aluminum or aluminum alloys comprising conventional wiring materials were employed, it was necessary to employ a maximum current value of only 5.6 × 10⁵ A/cm² in order to ensure a wiring service life of 10 years. However, in accordance with the increase in minuteness and speed of the semiconductor elements, if aluminum or aluminum alloy having, for example, a wiring width of 0.5 µm, and a wiring length of 100 m (resistivity: 3 × 10⁻⁶ Ω·cm) was employed, the current density reached a maximum value of 1 × 10⁶ A/cm² or more. In wiring using aluminum or aluminum alloy as a material therefor, the reliability thereof was extremely low when the wiring width was 1 µm or less.

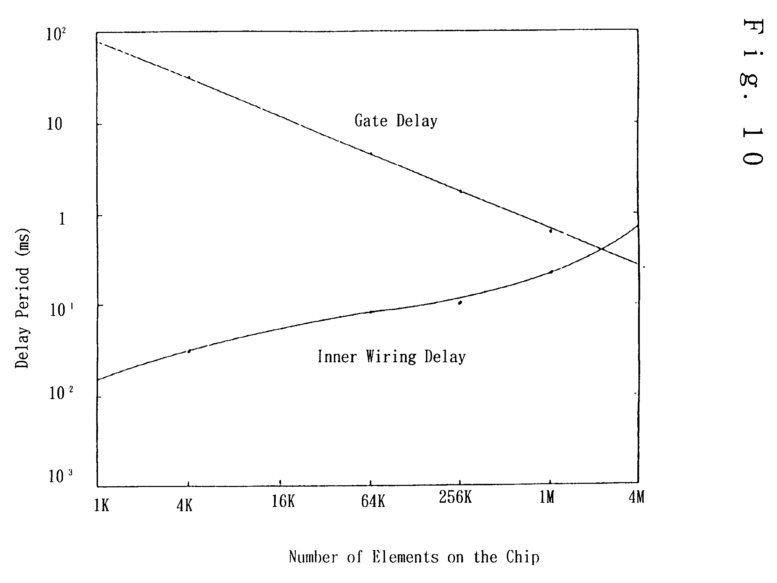

In Fig. 10, the relationship between response delay and the degree of minuteness in MOSLSI employing aluminum or aluminum alloy as a wiring material is shown. In concert with the increase in minuteness of MOSLSI, while the gate delay is reduced, the inner wiring delay is increased. In concert with the increase in LSI of the semiconductor elements, and the increase in the chip surface area, the wiring resistance, which is a primary cause of the inner wiring delay, is high when aluminum or aluminum alloy is employed, and this brings about a deterioration in the semiconductor element characteristics.

Furthermore, when aluminum or aluminum alloy is subjected to minute working using a photolithography technique, the reflectance of aluminum or aluminum alloy with respect, for example, to light having a wavelength of 436 nm is equal to or greater than 90%, and the light absorption at the boundary with the resist is increased, so that this leads to resist pattern deficiencies.

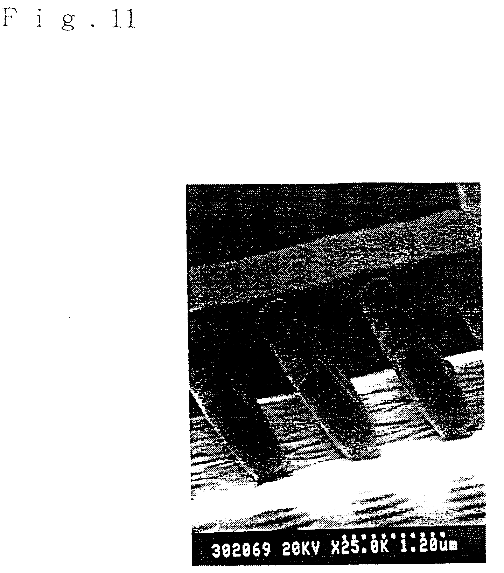

Fig. 11 is an electron micrograph showing a 0.6 µm positive-type photoresist pattern formed on an aluminum substrate. Pattern thinning occurs at the boundary between the aluminum substrate and the resist, and the pattern breaks down.

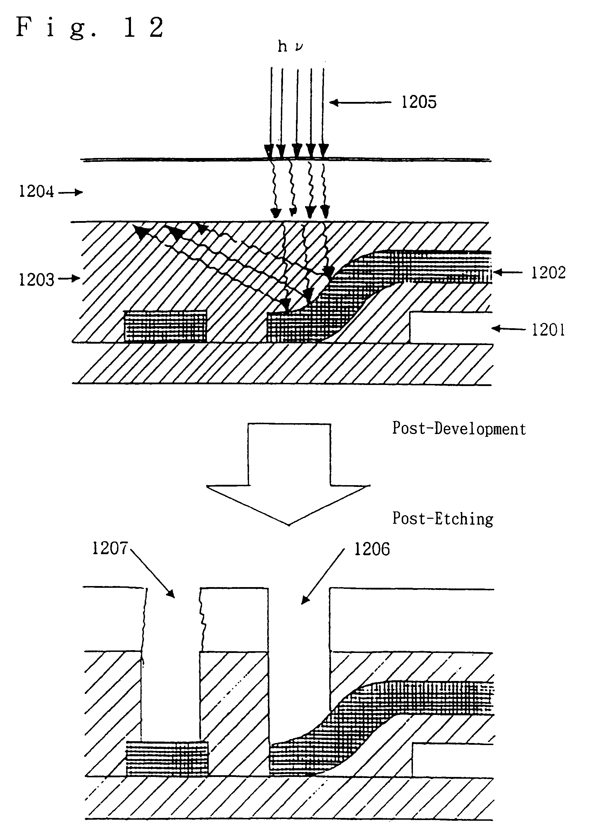

Furthermore, Fig. 12 shows the mechanism of the generation of a ghost pattern which is observed in lithography processes during the formation of multi-layer wiring. An aluminum first wiring 1202 is formed above polycrystalline silicon 1201, so that a structure having step separation is formed. An insulating film 1203 such as a silicon oxide film or the like which is completely flat is present directly above first wiring 1202, and furthermore, above this, a photoresist 1204 is formed. When an ultraviolet light 1205 is shone onto the photoresist at a predetermined position in order to connect the first wiring 1202 and the second wiring, this ultraviolet light 1205 penetrates resist 1204 and the insulating film 1203, and is reflected at the surface of the aluminum of first wiring 1202. When insulating film 1203 is subjected to etching in the course of the lithography process, in addition to the veer hole 1206 which was originally intended to be formed, an unnecessary veer hole 1207 is also formed.

In this manner, in aluminum substrates possessing a step separation, a pattern movement transfer phenomenon frequently occurs as a result of the mirror effect at the step separation. Presently, types of resists which prevent reflection are employed; however, the use of such types of resists which prevent reflection increase the complexity of the lithography process, so that the use thereof is not preferable. Furthermore, in developing processes in which a strongly alkaline solution is used, the aluminum or aluminum alloy is dissolved in the developing fluid at a rate of a few tens of nm/min. Accordingly, in photolithography techniques, highly precise minute working is difficult when aluminum or aluminum alloy are employed.

### Disclosure of the Invention

A first essential feature of the present invention resides in a semiconductor device, characterized in that copper wiring having a wiring width of 1 µm or less, and having a grain size which is ten or more times greater than the wiring width, is employed in at least a portion thereof.

A second essential feature of the present invention resides in a semiconductor device, characterized in that copper wiring having a wiring width of 0.5 µm or less, and having a grain size twenty or more times greater than the wiring width, is employed in at least a portion thereof.

A third essential feature of the present invention resides in a manufacturing method for semiconductor devices, characterized in comprising a process for forming at least one insulating film on the surface of a semiconductor substrate, a process for forming a thin copper film on this insulating film while irradiating the surface thereof with low energy ions, a process for conducting heat treatment at a temperature of 180°C or more, a process for applying a photosensitive material on the thin copper film, and a process for irradiating pre-specified regions on the photosensitive material with ultraviolet light.

In the present invention, the energy of the ions irradiated onto the surface is within a range of 10-120 eV; however, a range of 80-120 eV is preferable. At an energy of less than 10 eV, the grain size does not become extremely large even after the subsequent heat treatment.

Furthermore, the heat treatment is conducted at a temperature of 180°C or more. At a temperature of less than 180°C, almost no grain growth occurs.

### Brief Description of the Drawings

Fig. 1 is a schematic view of an RF-DC bias sputtering apparatus.

Fig. 2 is an image of the surface of a copper thin film after the heat treatment thereof was conducted at a temperature of 450°C and for a period of 30 minutes.

Fig. 3 is a diagram showing a measurement system used in the evaluation of electromigration.

Fig. 4 is a diagram showing the activation energy of each wiring.

Fig. 5 is a diagram showing the dependency of the resistivity of each wiring material on temperature.

Fig. 6 is a diagram showing the relationship between resistivity and grain size.

Fig. 7 is an explanatory diagram of a method of evaluation of the rate of incidence of resist pattern deficiencies.

Fig. 8 is a diagram showing the dependency of the rate of incidence of pattern deficiencies on pattern width.

Fig. 9 is an image of an isolated resist pattern formed on a copper substrate.

Fig. 10 is a diagram showing the relationship between the response delay in MOSLSI and the increase in minuteness thereof.

Fig. 11 is an image of a positive-type photoresist pattern formed on an aluminum substrate.

Fig. 12 is a diagram showing the mechanism of ghost pattern generation.

### (Description of the References)

- 101: chamber
- 102: target
- 103: sample
- 104: gas inlet
- 105: vacuum exhaust system
- 106: matching circuit
- 107: low pass filter
- 108: DC power source
- 301: sample
- 302: pad
- 303: direct current power source
- 304: direct current ammeter
- 305: direct current volt meter
- 306: computer
- 701: test pattern
- 702: sample surface
- 703: photoresist pattern
- 704: line
- 705: space
- 1201: polysilicon
- 1202: aluminum
- 1203: insulating film
- 1204: photoresist
- 1205: ultraviolet light
- 1206: veer hole
- 1207: ghost pattern

### Best Mode for Carrying Out the Invention

### (Embodiment 1)

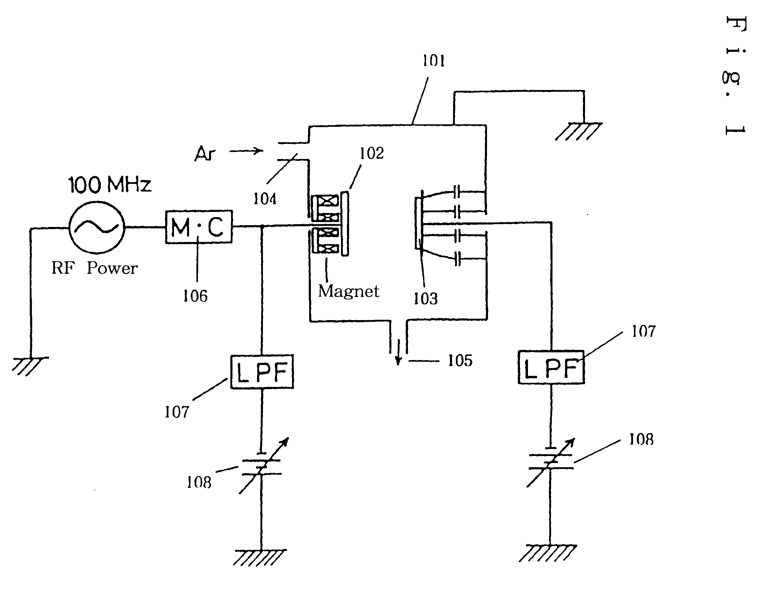

A first embodiment of the present invention will be explained using Figs. 1 through 4.

In the present invention shown in Fig. 1, a schematic diagram of a RF-DC bond bias sputtering apparatus, having as a characteristic feature thereof a low energy ion irradiation process which is employed in the formation of a thin copper film, is shown. The present apparatus comprises a chamber 101 and a copper target 102 in the interior thereof, a sample 103 which is disposed parallel to this, a gas inlet 104, and a vacuum exhaust system 105.

Furthermore, the RF power source which is employed in plasma discharge is connected to target 102 via a matching circuit 106. The potential of the target 102 and the sample 103 can be independently controlled via low pass filter 107. It is possible to control the ion energy irradiated onto the sample 103 by means of the DC power source 108 which is connected to sample 103, and the rate of film formation can be controlled by means of the DC power source 108 which is connected to target 102.

Vacuum exhaust system 105 comprises an oil-free turbo-molecular pump and a dry pump, and is capable of achieving an ultra-high vacuum within chamber 101 having a vacuum degree on a level of 10⁻¹⁰. Furthermore, sample 103 comprises, for example, Si, but other substrates may be employed. Argon gas of extremely high purity, for example, is supplied from gas inlet 104.

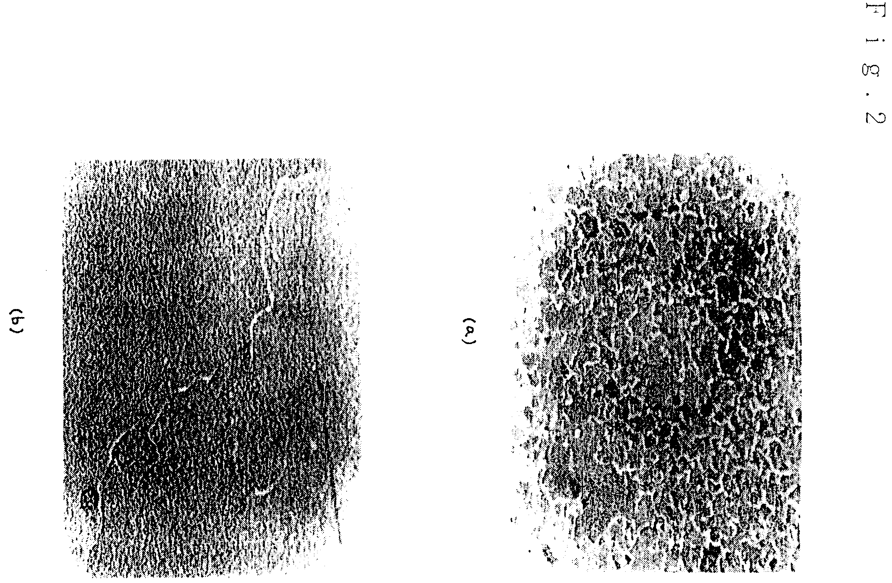

Fig. 2 is an image of the surface of a copper thin film formed by means of the present apparatus after heat treatment at a temperature of 450°C and for a period of 30 minutes; Fig. 2(b) is an enlarged image of Fig. 2(a). The film formation is conducted under the following conditions.
AR pressure: 3 mTorr
High frequency: 100 MHz
High frequency power: 30 W
Target bias: -150 ∼ 450 V
Substrate bias: +20 ∼ -80 V
Thickness of deposited film: 1 µm
It was determined that by means of heat treatment at a temperature of 450°C and for a period of 30 minutes, the grain size grew to a size of 50 µm or more. By means of the above apparatus, copper wiring and conventional aluminum or aluminum alloy wiring were formed, and the resistance to electromigration in these wirings was compared.

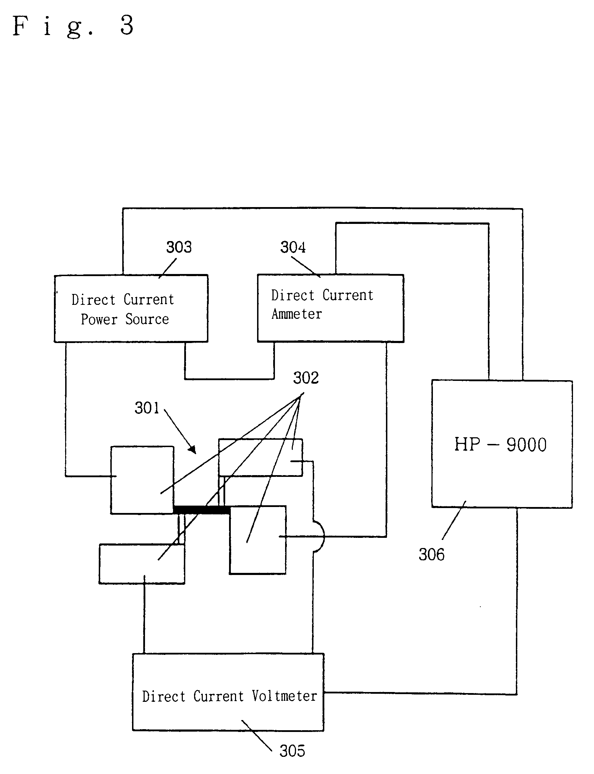

Fig. 3 shows a measurement system used in the evaluation of this electromigration.

A direct current ammeter 304 and a direct current volt meter 305, which are connected in series to direct current power source 303, are connected to sample 301 via pads 302, and these are controlled by computer 306. At a high temperature on the level of 100°C, a large current stress of 10⁷ A/cm² was applied to the wiring for one cycle, and the point in time at which the amount of increase in the resistance at normal temperatures reached 5% was determined to be the service life of the wiring.

As a result, when a current of an identical size was passed through copper wiring possessing an extremely enlarged grain which was 10 or more times the wiring width as a result of heat treatment, it was determined that service life during which migration resistance was exhibited could be guaranteed which was, at room temperature, within a range of 10 to 100 times that of aluminum-silicon-copper wiring, and furthermore, it was determined that if the same wiring service life were guaranteed, it would be possible to pass a current through the wiring which was greater by one to two decimal places than that conventionally possible.

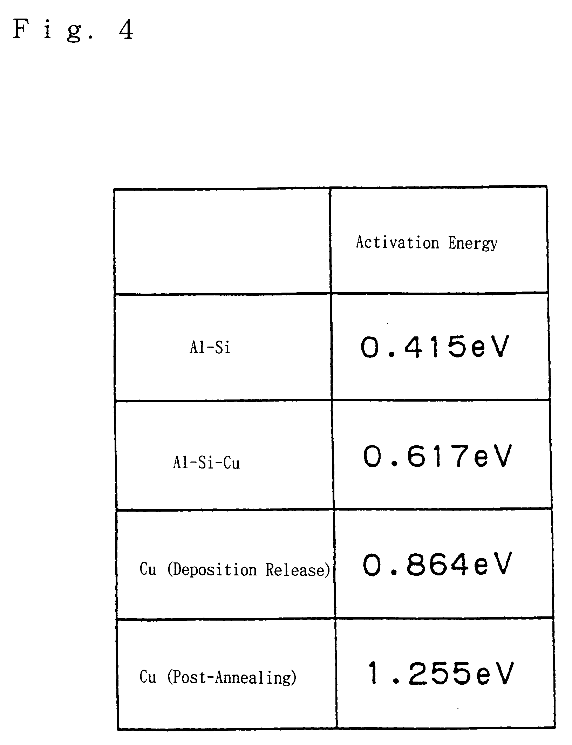

In Fig. 4, the activation energy of various wirings is shown. The greater the activation energy of the wiring, the longer the service life. In contrast to aluminum or aluminum alloy, which were the conventional wiring materials, the activation energy of copper wiring is large, and in particular, it was determined that copper wiring having an extremely large grain (Cu wiring (post-annealing)) possesses an activation energy which is two or more times that of Al-Si-Cu wiring.

Furthermore, at wiring widths of less than or equal to 0.5 µm, if the activation energy of the wiring is not greater than or equal to 1 eV, the wiring will not stably function for a period of 10 years. It was determined from the relationship between the activation energy of copper wiring and the grain size thereof that in order to obtain an activation energy of 1 eV, it is necessary to make the grain size 20 or more times the wiring width. It was confirmed that by using wiring having a wiring width of less than or equal to 1 µm and a grain size of 10 or more times the wiring width, or by using copper wiring having a wiring width of 0.5 µm and a grain size 20 or more times the wiring width, the service life of the wiring is dramatically improved in comparison with that of conventional wiring.

### (Embodiment 2)

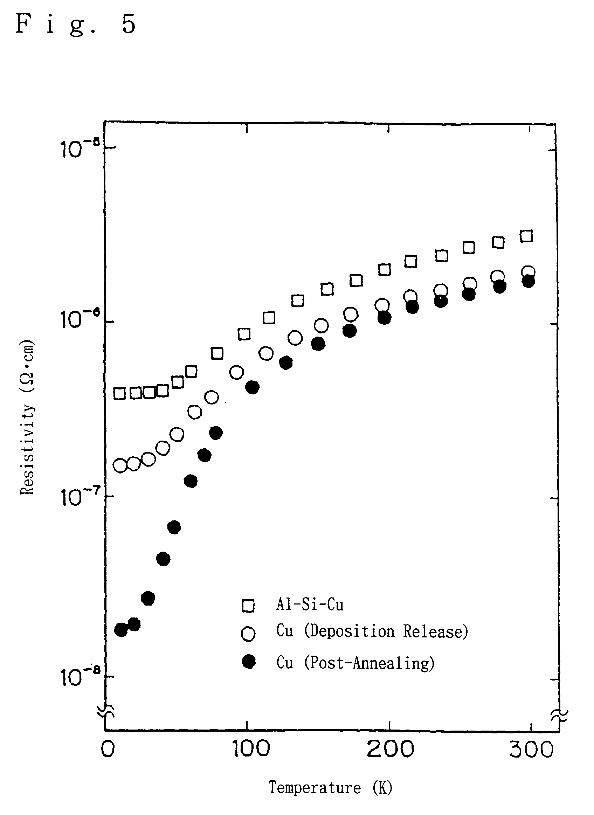

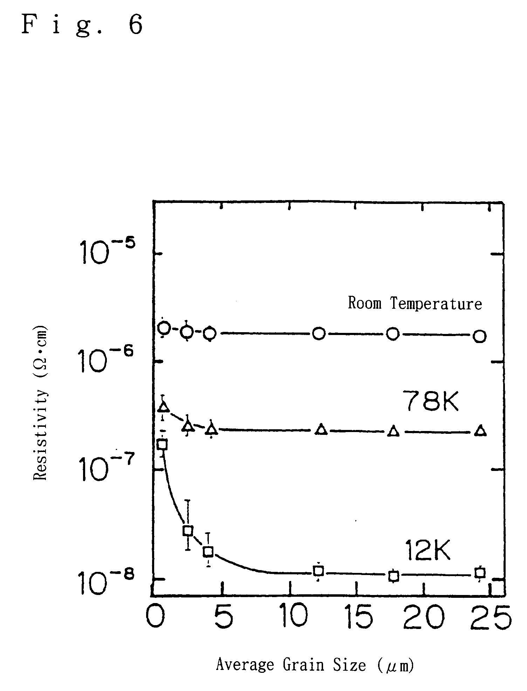

A second embodiment of the present invention will be explained using Figs. 5 and 6.

In the present embodiment, the apparatus which is employed in the formation of the thin copper film, and the explanation of the details of the heat treatment, are identical to those of Embodiment 1, so that an explanation thereof will be omitted here.

The copper wiring formed by means of the present apparatus and conventional aluminum or aluminum alloy wiring were used, and the resistivity thereof was measured and compared.

Fig. 5 shows the dependency of the resitivity of the various wiring materials on temperature. At room temperature, the resistivities of the various wiring materials are as follows: that of aluminum is 2.73 µΩ·cm, the resistivity of aluminum-silicon-copper is 3.20 µΩ·cm, and the resistivity of copper is 1.72 µΩ·cm, so that it is clear that the resistivity of copper is the lowest. Furthermore, it was confirmed that with respect to resistivities at the extremely low temperature of 12K, copper having an extremely enlarged grain as a result of heat treatment has a resistivity which is reduced by 1.5 decimal places or more in comparison with that of aluminum-silicon-copper.

Fig. 6 shows the relationship between the resistivity of copper and the grain size thereof. During low temperature operation, an improvement in the resistivity of copper was observed at grain sizes of 5 µm or more. However, in light of measurement variation, it is clear that a grain size of 10 µm or more is necessary in order to stably guarantee the resistivity of the copper wiring at low temperatures. That is to say, it is necessary that the grain size be 10 or more times the wiring width in the case of wiring having a width of 1 µm, and a grain size of 20 or more times the wiring width is necessary in the case of wiring having a width of 0.5 µm. When the wiring width in the present invention was 1 µm or less, copper having a grain size which was 10 times or more the wiring width was used as the wiring material, a MOSLSI was produced, and this was operated at low temperatures, it was determined that the inner wiring delay which was conventionally observed was improved, and that no decline in the characteristics of the semiconductor elements occurred.

### (Embodiment 3)

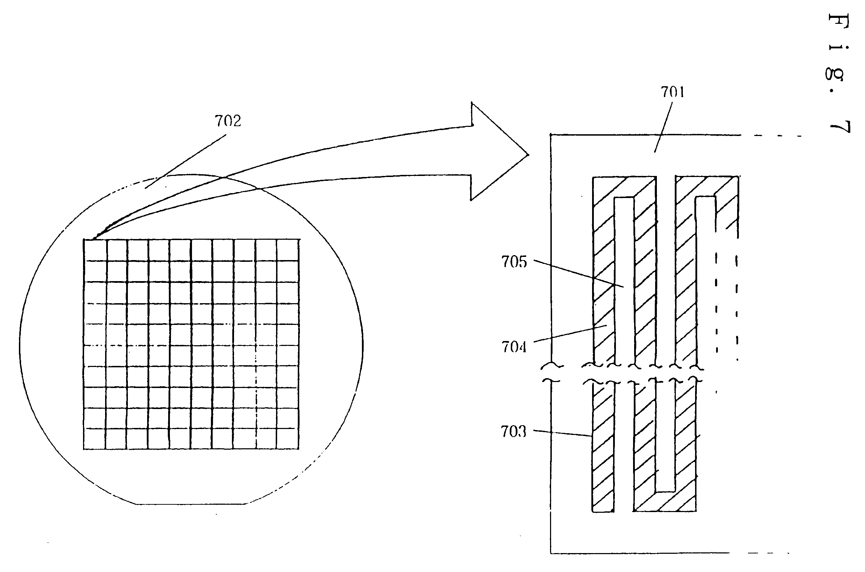

A third embodiment of the present invention will be explained using Figs. 7 through 10.

The apparatus used in the formation of the thin copper film in the present invention, and the explanation of the details of the heat treatment, are identical to those in Embodiments 1 and 2 above, so that an explanation thereof will be omitted here.

A resist pattern was formed by means of a photolithographic technique on the thin copper film formed by means of the present apparatus, and on a conventional aluminum or aluminum alloy thin film. The rate of incidence of resist pattern deficiencies was compared.

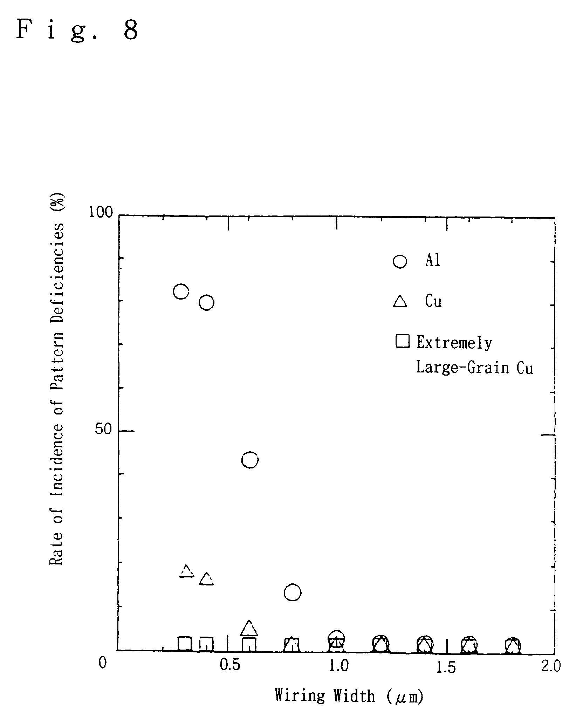

Fig. 7 relates to an evaluation method for the rate of incidence of resist pattern defects. A metallic thin film having a thickness of 1 µm was formed on an n-type (100) silicon substrate having a diameter of 5 inches, and furthermore, a positive type photoresist layer having a thickness of 1.26 µm was formed thereon. A test pattern 701 was exposed on the sample surface 702 for 100 shots, 1 shot having a 5 mm target, by means of a demagnification projection aligner. The test pattern 701 was so disposed that the ratio between the lines 704 and the space 705 of the photoresist pattern 703 within a 5 mm target was 1:1. For example, setting was conducted so that the total length of a resist pattern having a line width of 1 µm was 50 m. In the present embodiment, test patterns having a line width within a range of from 2 µm to 0.3 µm were prepared. After passing through exposure and wet development processes, the resist pattern was examined using a scanning electron microscope after spin cleaning. Resist patterns having at least one disconnection within a 5 mm target or within which pattern breakdown was observed were determined to have pattern deficiencies. A 100-point measurement was conducted with respect to each sample, and a rate of incidence of pattern deficiencies was determined. In Fig. 8, the dependency of the rate of incidence of pattern deficiencies on pattern width in various metallic substrates is shown. The rate of incidence of pattern deficiencies in aluminum or aluminum alloy substrates began to appear at wiring widths of 1 µm, and at widths of 0.5 µm or less, a rate of incidence of deficiencies of 50% or more was observed.

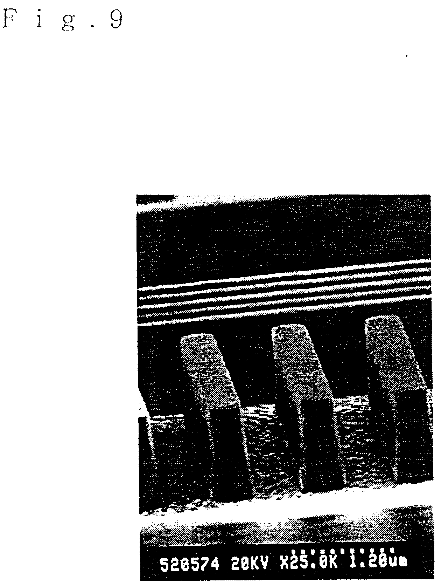

In contrast, with copper wiring, in the case in which heat treatment was not conducted, a rate of incidence of deficiencies was observed in patterns of less than 0.5 µm, while in the case in which heat treatment was conducted and an extremely large grain was formed, no rate of incidence of deficiencies was observed down to a size of 0.3 µm. To consider the causes of this, in the case in which heat treatment is not conducted, the grain size of the copper is small, at 0.2∼0.3 µm, and as a result of reflection from the numerous grain boundaries, a rate of incidence of deficiencies is present at sizes of less than or equal to 0.5 µm. Fig. 9 shows an isolated photoresist pattern of 0.6 µm formed on a copper substrate. It was confirmed that resist thinning, which was observed at the substrate boundary surface on conventional aluminum substrates, did not occur. This phenomenon occurs because the reflectance of an aluminum or aluminum alloy substrate, with respect, for example, to light having a wavelength of 436 nm, is on the level of 90%, while the reflectance of a copper substrate is on the level of 50%, which is considered optimum for the exposure conditions. Furthermore, in the case in which copper wiring was employed as a first level wiring, the occurrence of ghost patterns in the resist as a result of step separation, which was observed in aluminum wiring or in aluminum alloys, did not occur. It was learned that a highly precise resist pattern could be formed on a copper substrate. In the case in which the designed wiring width was 1 µm or less, it was confirmed that highly precise minute working can be conducted on a copper thin film possessing a grain size which is 10 or more times the wiring width, by means of photolithographic techniques.

### Industrial Applicability

In accordance with the invention as stated in Claims 1 and 2, it is possible to provide a semiconductor device having superior migration resistance, having a long service life, and having little inner wiring delay.

In accordance with the invention as stated in Claim 7, it is possible to conduct highly precise minute working by means of photolithographic techniques, and thus to achieve a reduction in the rate of incidence of deficiencies.

## Claims

1. A semiconductor device, characterized in that copper wiring having a wiring width of 1 µm or less and a grain size 10 or more times the wiring width is employed in at least a portion thereof.

2. A semiconductor device, characterized in that copper wiring having a wiring width of 0.5 µm or less and a grain size 20 or more times the wiring width is employed in at least a portion thereof.

3. A semiconductor device in accordance with one of Claims 1 and 2, characterized in that metal wiring is provided above said copper wiring, via at least one insulating film provided with a predetermined opening.

4. A semiconductor device in accordance with Claim 3, characterized in that said metal wiring is formed of copper.

5. A semiconductor device in accordance with Claim 4, characterized in that said metal wiring has a wiring width of 1 µm or less, and is formed from copper having a grain size 10 or more times said wiring width.

6. A semiconductor device in accordance with Claim 4, characterized in that said metal wiring has a wiring width of 0.5 µm, and is formed from copper having a grain size 20 or more times said wiring width.

7. A manufacturing method for semiconductor devices, characterized in comprising:
a process for forming at least one insulating film on a surface of a semiconductor substrate,
a process for forming a thin copper film on said insulating film while irradiating a surface thereof with ions having a low energy within a range of 10∼120 eV or more,
a process for conducting heat treatment at a temperature of 180°C or more,
a process for applying a photosensitive material on said thin copper film, and
a process for irradiating predetermined regions on said photosensitive material with ultraviolet light.
